# DEMANDE DE BREVET EUROPEEN

(11) **EP 4 783 146 A1**
(43) Date de publication de la demande: **29.07.2026**
(21) Numéro de dépôt: 25153667.8
(22) Date de dépôt: 23.01.2025
(51) Int. Cl.: G09F 9/30, G09F 19/22, G09F 23/00, A63B 71/06, G07C 1/22, G07C 1/28

(54) **PANNEAU D'AFFICHAGE ÉLECTRONIQUE, NOTAMMENT POUR UN ÉVÈNEMENT SPORTIF, COMPRENANT UN CACHE D'ORNEMENT AMOVIBLE**

(71) Demandeur: Swiss Timing Ltd, 2606 Corgémont (CH)
(72) Inventeur: WEGMANN, Valentin, 1717 St. Ursen (CH); THOMASIUS, Michael, 04158 Leipzig (DE); MENOUX, Regis, 2619 Saint-Imier (CH)
(74) Mandataire: ICB SA

(57) **Abrégé**

Un aspect de l'invention concerne un panneau d'affichage électronique (1), notamment pour un événement sportif, comprenant une armature (2) destinée à être accrochée pour suspendre le panneau d'affichage (1), ainsi qu'un écran d'affichage (3) monté sur l'armature (2), le panneau d'affichage (1) comportant un cache d'ornement (4) amovible apte à être monté sur l'armature (2) pour la dissimuler, et des moyens de fixation (5) amovibles du cache d'ornement (4, 40) sur l'armature (2), l'armature (2) et le cache d'ornement (4) étant au moins en partie de forme circulaire pour pouvoir faire coulisser en rotation le cache d'ornement (4) sur l'armature (2) entre deux positions, une première position de positionnement, dans laquelle les moyens de fixation amovibles (5) permettent de positionner le cache d'ornement (4) contre l'armature (2), et une deuxième position d'assemblage dans laquelle les moyens de fixation (5) amovibles rendent le cache d'ornement (4) et l'armature (2) solidaires l'un de l'autre.

## Description

### Domaine technique de l'invention

L'invention concerne un panneau d'affichage électronique, notamment pour un évènement sportif, le panneau d'affichage comprenant un cache d'ornement amovible.

### Arrière-plan technologique

Lors d'évènements sportifs, on utilise souvent un panneau d'affichage électronique pour indiquer aux spectateurs et aux joueurs certaines informations, tels que le score et/ou le temps de jeu en cours.

Un tel panneau d'affichage est particulièrement important dans certaines disciplines, où des temps de jeu limités sont octroyés à tour de rôle à l'une ou l'autre équipe. Par exemple pendant un match de basket, chaque équipe a le droit de posséder la balle pendant un temps limité (24 secondes actuellement). Ainsi, le panneau d'affichage égrène le temps de jeu qu'il reste à l'équipe pour essayer de marquer un panier. En outre, le panneau d'affichage affiche le temps de jeu, et de préférence le score entre les équipes.

Le panneau d'affichage comprend une armature destinée à être accrochée pour suspendre le panneau d'affichage, par exemple pour être monté au-dessus d'un panier de basket. Le panneau d'affichage comprend également au moins un écran d'affichage monté sur l'armature. Par exemple, au moins une partie de l'armature entoure l'écran d'affichage, et délimite le panneau d'affichage.

Dans le basket, notamment dans la ligue américaine NBA, les panneaux d'affichage sont généralement carrés. Ainsi, l'armature entourant l'écran d'affichage est de forme carrée.

Pour améliorer l'esthétique de ces panneaux d'affichage, on dispose un cache d'ornement sur l'armature pour la dissimuler. Ainsi, le cache d'ornement entoure au moins en partie l'écran d'affichage. Le cache d'ornement est fixé à l'armature par des moyens de fixation usuels, tels que des vis.

Pour rendre le panneau d'affichage encore plus attrayant, le cache d'ornement comporte des motifs ou des couleurs, représentant par exemple une équipe ou un évènement sportif particulier.

Par conséquent, il est nécessaire de changer le cache d'ornement pour certains matchs, voire à chaque match, afin de présenter une parure spécifique à l'évènement sportif.

Or, les moyens de fixation utilisés connus ne sont pas pratiques, et ne permettent pas un changement rapide du cache d'ornement.

### Résumé de l'invention

L'invention a pour but de faciliter le changement de cache d'ornement sur des panneaux d'affichage, notamment d'évènement sportif.

A cet effet, l'invention concerne un panneau d'affichage électronique, notamment pour un évènement sportif, comprenant une armature destinée à être accrochée pour suspendre le panneau d'affichage, ainsi qu'un écran d'affichage monté sur l'armature, le panneau d'affichage comportant un cache d'ornement amovible apte à être monté sur l'armature pour la dissimuler, et des moyens de fixation amovibles du cache d'ornement sur l'armature.

L'invention est remarquable en ce que l'armature et le cache d'ornement sont au moins en partie de forme circulaire pour pouvoir faire coulisser en rotation le cache d'ornement sur l'armature entre deux positions, une première position de positionnement, dans laquelle les moyens de fixation amovibles permettent de positionner le cache d'ornement contre l'armature, et une deuxième position d'assemblage, dans laquelle les moyens de fixation amovibles rendent le cache d'ornement et l'armature solidaires l'un de l'autre.

Ainsi, la forme circulaire de l'armature et du cache d'ornement, le cache d'ornement peut glisser en rotation sur l'armature dans un mouvement circulaire. Cette caractéristique permet d'utiliser des moyens de fixation pour lesquels, dans une première position de positionnement, le cache d'ornement est positionné sur l'armature, et une deuxième position d'assemblage, dans laquelle le cache d'ornement et l'armature sont solidaires l'un de l'autre.

Grâce à l'invention, le cache d'ornement peut être assemblé ou séparé de l'armature rapidement et facilement, en coulissant le cache d'ornement sur l'armature en rotation, dans un sens pour les assembler, et dans le sens inverse pour les séparer.

Selon un mode de réalisation particulier de l'invention, les moyens de fixation comprennent une pluralité de trous répartis sur une face avant de l'armature et une pluralité de plots agencés sur une face arrière du cache d'ornement, chaque plot coopérant avec un trou dans la première position de positionnement et dans la deuxième position d'assemblage.

Selon un mode de réalisation particulier de l'invention, les trous comportent une portion de positionnement munie d'une ouverture élargie et une portion d'assemblage munie d'une ouverture réduite.

Selon un mode de réalisation particulier de l'invention, les plots comportent un corps s'étendant depuis la face arrière et une tête plus large que le corps.

Selon un mode de réalisation particulier de l'invention, la tête des plots est plus large que l'ouverture réduite de la portion d'assemblage, et moins large que l'ouverture élargie de la portion de positionnement.

Selon un mode de réalisation particulier de l'invention, le corps des plots est moins large que l'ouverture réduite de la portion d'assemblage et que l'ouverture élargie de la portion de positionnement.

Selon un mode de réalisation particulier de l'invention, le panneau d'affichage comprend en outre des moyens de verrouillage pour retenir le cache d'ornement dans la position d'assemblage en l'empêchant de tourner.

Selon un mode de réalisation particulier de l'invention, les moyens de verrouillage comprennent un premier trou de verrouillage agencé à travers la face supérieure du cache d'ornement, et un deuxième trou de verrouillage agencé à travers la face supérieure de l'armature, ainsi qu'un loquet amovible configuré pour pouvoir être inséré dans le premier et le deuxième trou de verrouillage.

Selon un mode de réalisation particulier de l'invention, le premier trou de verrouillage et le deuxième trou de verrouillage sont en vis-à-vis, lorsque le cache d'ornement est dans la position d'assemblage sur l'armature.

Selon un mode de réalisation particulier de l'invention, le cache d'ornement a une forme d'anneau.

Selon un mode de réalisation particulier de l'invention, l'armature et le cache d'ornement entourent le premier écran d'affichage en entier.

Selon un mode de réalisation particulier de l'invention, le panneau d'affichage comprend des moyens pour être suspendu en hauteur.

Selon un mode de réalisation particulier de l'invention, le panneau d'affichage comprend un deuxième écran d'affichage agencé sous le premier écran d'affichage.

Selon un mode de réalisation particulier de l'invention, le cache d'ornement comprend une partie rectangulaire destinée à entourer le deuxième écran d'affichage.

Selon un mode de réalisation particulier de l'invention, le panneau d'affichage comprend des moyens de suspension pour pouvoir être suspendu.

### Brève description des figures

Les buts, avantages et caractéristiques de l'invention seront mieux compris à la lecture de la description détaillée qui va suivre, en référence aux dessins annexés, où :
- la figure 1 est une représentation schématique d'une vue de face d'un panneau d'affichage selon un premier mode de réalisation de l'invention, dans une configuration où le cache d'ornement est assemblé sur l'armature ;
- la figure 2 est une représentation schématique d'une vue en perspective du panneau d'affichage de la figure 1 ;
- la figure 3 est une représentation schématique d'une vue en perspective du panneau d'affichage de la figure 1, dans une configuration où le cache d'ornement est séparé de l'armature ;
- la figure 4 est une représentation schématique d'une vue en perspective agrandie d'une partie du panneau d'affichage dans une configuration où le cache d'ornement est séparé de l'armature ;
- la figure 5 est une représentation schématique d'une vue de face agrandie d'une partie des moyens de fixation ;
- la figure 6 est une représentation schématique d'une vue de face agrandie de l'autre partie des moyens de fixation ;
- la figure 7 est une représentation schématique en gros plan des moyens de verrouillage du panneau d'affichage ; et
- la figure 8 est une représentation schématique d'une vue en perspective d'un panneau d'affichage selon un deuxième mode de réalisation de l'invention dans une configuration où le cache d'ornement est séparé de l'armature .

### Description détaillée de l'invention

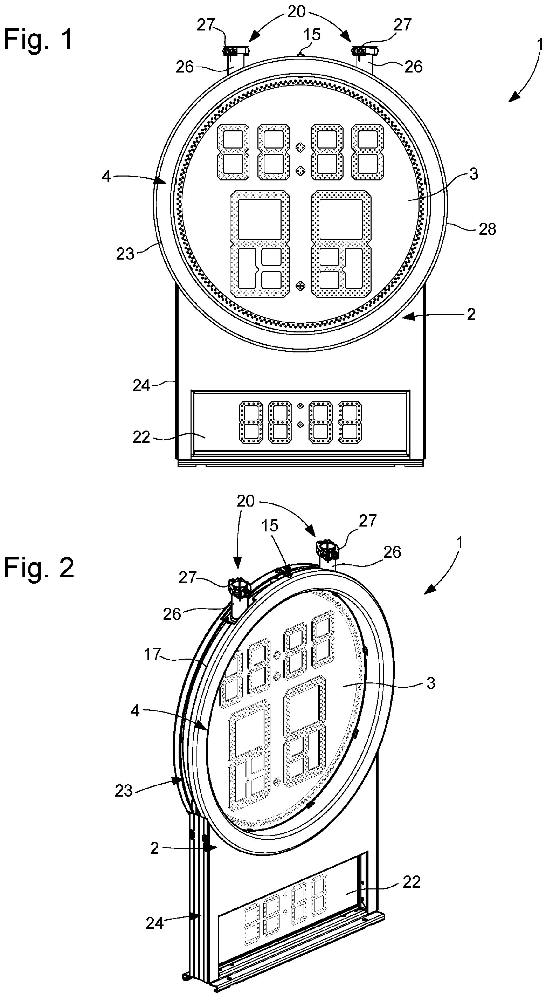

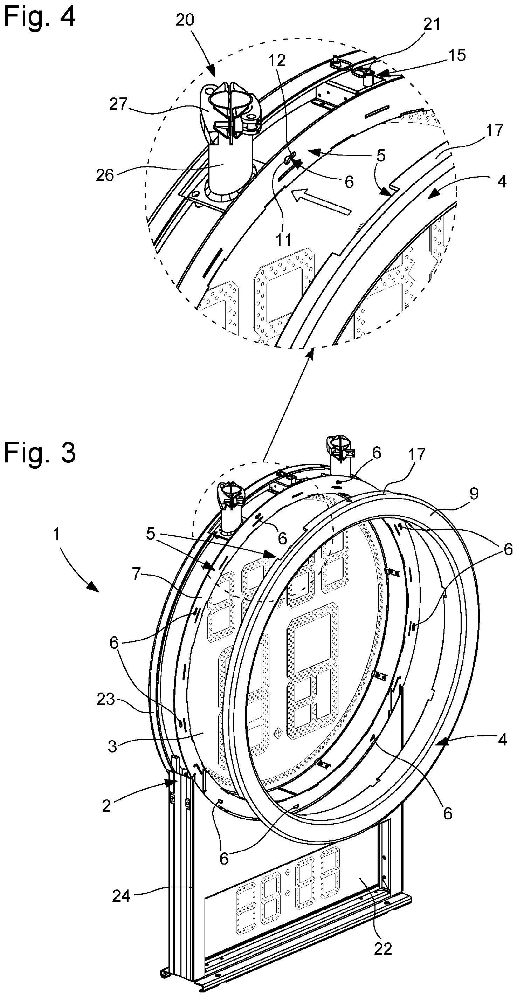

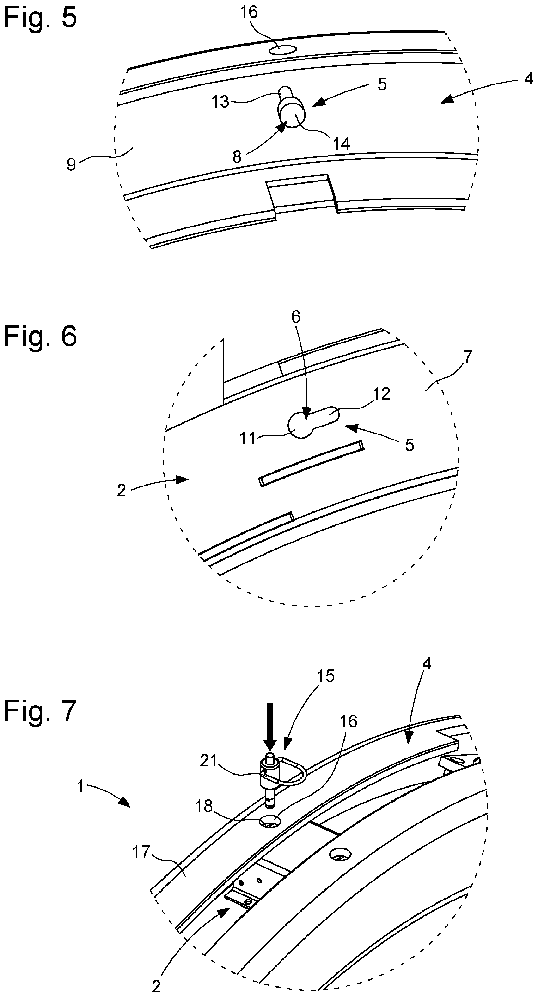

Sur les figures 1 à 7, l'invention se rapporte à un premier mode de réalisation de panneau d'affichage 1 électronique, notamment pour un évènement sportif, le panneau d'affichage 1 étant par exemple configuré pour afficher un score et/ou de temps, notamment pour un match de basket.

Le panneau d'affichage 1 comprend une armature 2 destinée à être accrochée pour suspendre le panneau d'affichage 1, par exemple pour être monté au-dessus d'un panier de basket, ainsi qu'un premier écran d'affichage 3 monté sur l'armature 2. Par exemple, le premier écran d'affichage 3 sert à afficher un ou plusieurs décomptes de temps de jeu.

Le premier écran d'affichage 3 est circulaire, et est entouré par l'armature 2, qui comprend une partie circulaire 23.

Dans ce mode de réalisation, le panneau d'affichage 1 comprend un deuxième écran d'affichage 22 agencé en-dessous du premier écran d'affichage 3. Le deuxième écran d'affichage 22 est rectangulaire et est également entouré de l'armature 2, qui comprend une partie rectangulaire 24 agencée en-dessous de la partie circulaire 23.

Le panneau d'affichage 1 comprend des moyens de suspension 20 pour être suspendu en hauteur, par exemple au-dessus du panier de basket. Sur les figures, les moyens de suspension 20 comprennent deux tubes 26 agencés au-dessus de l'armature 2 et un système de serrage 27 des tubes 26 pour les serrer autour d'un bras inséré dans les tubes 26. Le système de serrage 27 comporte un levier configuré pour serrer l'extrémité des tubes, les extrémités étant coupées en deux parties longitudinales séparées par un espace, les deux parties pouvant être rapprochées l'une de l'autre par les moyens de serrage.

Le panneau d'affichage 1 comprend aussi un dispositif électronique (non représenté sur les figures), permettant de contrôler et d'actionner l'affichage d'informations sur le premier écran d'affichage. Le dispositif électronique est de préférence logé dans un compartiment de l'armature 2 et est relié électriquement au premier écran d'affichage 3.

En outre, le panneau d'affichage 1 comporte un cache d'ornement 4 amovible apte à être monté sur l'armature 2 pour la dissimuler.

Le panneau d'affichage 1 comprend aussi des moyens de fixation 5 amovibles du cache d'ornement 4 sur l'armature 2, les moyens de fixation 5 étant agencés sur l'armature 2 et sur le cache d'ornement 4.

Selon l'invention, l'armature 2 et le cache d'ornement 4 sont au moins en partie de forme circulaire pour pouvoir faire tourner le cache d'ornement 4 sur l'armature 2 entre deux positions. Une première position de positionnement du cache d'ornement 4 sur l'armature 2, dans laquelle les moyens de fixation 5 sont engagés pour positionner le cache d'ornement 4 sur l'armature 2, et une deuxième position d'assemblage dans laquelle le cache d'ornement 4 et l'armature 2 sont solidaires l'un de l'autre.

Le cache d'ornement 4 a ici une forme d'anneau circulaire, correspondant sensiblement à la partie circulaire 23 de l'armature 2. Grâce à ces formes circulaires, le cache d'ornement 4 peut coulisser sur une face avant 7 de l'armature. Ainsi, l'armature 2 et le cache d'ornement 4 entourent le premier écran d'affichage 3.

Le cache d'ornement 4 comprend une paroi latérale 17, destinée à entourer au moins en partie l'armature 2.

Les moyens de fixation 5 comprennent une pluralité de trous 6 répartis sur la face avant 7 de l'armature 2 et une pluralité de plots 8 agencés sur une face arrière du cache d'ornement 4. De préférence, les trous 6 et les plots 8 sont répartis angulairement de manière homogène autour de le premier écran d'affichage 3, respectivement sur l'armature 2 et sur le cache d'ornement 4.

Ils sont disposés de sorte que chaque plot 8 coopère avec un trou 6 dans la première position de positionnement et aussi dans la deuxième position d'assemblage.

A cette fin, les trous 6 comportent une portion de positionnement munie d'une ouverture élargie 11 et une portion d'assemblage munie d'une ouverture réduite 12. Les deux ouvertures,11, 12 sont contiguës et continues pour chaque trou 6.

Les plots 6 comportent un corps 13 s'étendant depuis la face arrière 9 du cache d'ornement 4 et une tête 14 plus large que le corps 13. La tête 14 des plots 6 est plus large que l'ouverture réduite 12 de la portion d'assemblage, et moins large que l'ouverture élargie 11 de la portion de positionnement. Tandis que le corps 13 des plots 8 est moins large que l'ouverture réduite 12 de la portion d'assemblage et moins large que l'ouverture élargie 11 de la portion de positionnement.

Ainsi, dans la première position de positionnement, les plots 8 sont introduits dans l'ouverture élargie 11 des trous 6. Puis par un mouvement de rotation du cache d'ornement 4 sur l'armature 2, les plots 8 coulissent dans l'ouverture réduite 12, de sorte que le cache d'ornement 4 et l'armature 2 sont solidaires l'un de l'autre, car les plots 8 ne peuvent plus sortir des trous 6, leurs têtes 14 étant retenues par le bord de l'ouverture réduite 12.

Le panneau d'affichage 1 comprend en outre des moyens de verrouillage 15 pour retenir le cache d'ornement 4 dans la position d'assemblage, en particulier pour l'empêcher de tourner dans le sens inverse et éviter de le ramener dans la première position de positionnement. Dans ce mode de réalisation, les moyens de verrouillage 15 sont agencés sur le dessus du panneau d'affichage 1.

Les moyens de verrouillage 15 comprennent un premier trou de verrouillage 16 agencé à travers la paroi latérale 17 du cache d'ornement 4, et un deuxième trou de verrouillage 18 agencé sur une face supérieure 19 de l'armature 2.

Le premier trou de verrouillage 16 et le deuxième trou de verrouillage 18 sont agencés de sorte qu'ils soient en vis-à-vis, lorsque le cache d'ornement 4 est dans la deuxième position d'assemblage.

Les moyens de verrouillage 15 comportent encore un loquet 21 amovible configuré pour pouvoir être inséré dans le premier 16 et le deuxième trou de verrouillage 18, lorsqu'ils sont en vis-à-vis. Lorsque l'armature 2 et le cache d'ornement 4 sont dans la deuxième position d'assemblage, le loquet 21 peut être inséré à travers le premier 16 et le deuxième trou de verrouillage 18, et reste dans cette disposition. Ainsi, le loquet 21 retient le cache d'ornement 4 angulairement, ce dernier ne pouvant plus tourner pour revenir dans la première position de positionnement.

Le cache d'ornement 4 est donc verrouillé sur l'armature 2, car il est retenu angulairement par les moyens de verrouillage 15, et il est retenu axialement par les moyens de fixation 5.

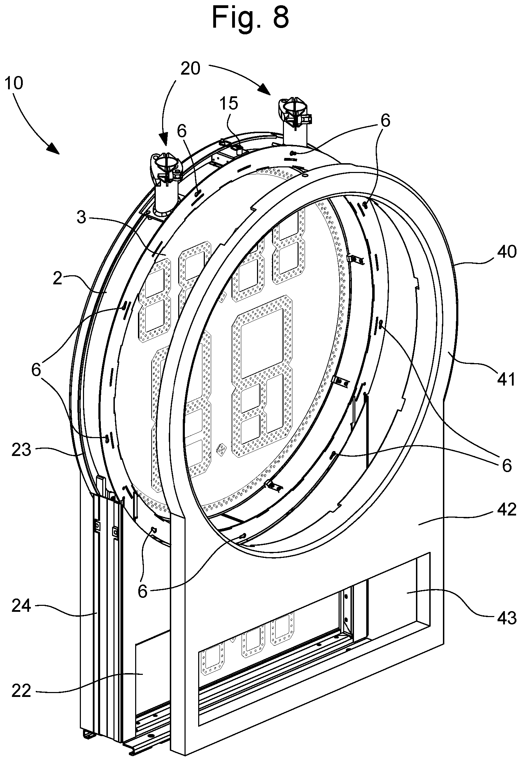

Dans le deuxième mode de réalisation de la figure 8, le cache d'ornement 40 du panneau d'affichage 10 comprend une partie rectangulaire 42 en dessous de l'anneau 41, qui peut être placé sur la partie rectangulaire 24 de l'armature 2 autour du deuxième écran d'affichage 22, lorsque le cache d'ornement 40 est en position d'assemblage. La partie rectangulaire 42 comprend une ouverture traversante 43 permettant de voir le deuxième écran d'affichage 22. En dehors du cache d'ornement 40, les autres caractéristiques du panneau d'affichage 10 sont identiques à celle du premier mode de réalisation de panneau d'affichage 1, en particulier pour les moyens de fixation 5 et l'armature 2.

Les panneaux d'affichage 1, 10 de ces deux modes de réalisation peuvent comprendre deux caches d'ornement, un de chaque côté de l'armature 2, notamment si les écrans sont lisibles deux côtés.

Naturellement, l'invention n'est pas limitée aux modes de réalisation décrits en référence aux figures, et des variantes pourraient être envisagées sans sortir du cadre de l'invention. En effet le panneau d'affichage pourrait être utilisé dans un autre cadre que celui d'un évènement sportif. On peut l'utiliser par exemple pour afficher des messages pendant un spectacle, dans centres commerciaux, des parkings, sur des voies de circulation, ou des centres-villes.

## Revendications

1. Panneau d'affichage électronique (1, 10), notamment pour un évènement sportif, comprenant une armature (2) destinée à être accrochée pour suspendre le panneau d'affichage (1, 10), ainsi qu'un écran d'affichage (3) monté sur l'armature (2), le panneau d'affichage (1, 10) comportant un cache d'ornement (4, 40) amovible apte à être monté sur l'armature (2) pour la dissimuler, et des moyens de fixation (5) amovibles du cache d'ornement (4, 40) sur l'armature (2), **caractérisé en ce que** l'armature (2) et le cache d'ornement (4, 40) sont au moins en partie de forme circulaire pour pouvoir faire coulisser en rotation le cache d'ornement (4, 40) sur l'armature (2) entre deux positions, une première position de positionnement, dans laquelle les moyens de fixation amovibles (5) permettent de positionner le cache d'ornement (4, 40) contre l'armature (2), et une deuxième position d'assemblage dans laquelle les moyens de fixation (5) amovibles rendent le cache d'ornement (4, 40) et l'armature (2) solidaires l'un de l'autre.

2. Panneau d'affichage selon la revendication 1, **caractérisé en ce que** les moyens de fixation (5) comprennent une pluralité de trous (6) répartis sur une face avant (7) de l'armature (2), et une pluralité de plots (8) agencés sur une face arrière (9) du cache d'ornement (4), chaque plot (8) coopérant avec un trou (6) dans la première position de positionnement et dans la deuxième position d'assemblage.

3. Panneau d'affichage selon la revendication 2, **caractérisé en ce que** les trous (6) comportent une portion de positionnement munie d'une ouverture élargie (11) et une portion d'assemblage munie d'une ouverture réduite (12).

4. Panneau d'affichage selon la revendication 3, **caractérisé en ce que** les plots (8) comportent un corps (13) s'étendant depuis la face arrière (9) et une tête (14) plus large que le corps (13).

5. Panneau d'affichage selon la revendication 4, **caractérisé en ce que** la tête (14) des plots (8) est plus large que l'ouverture réduite (12) de la portion d'assemblage, et moins large que l'ouverture élargie (11) de la portion de positionnement.

6. Panneau d'affichage selon la revendication 5, **caractérisé en ce que** le corps (13) des plots (8) est moins large que l'ouverture réduite de la portion d'assemblage et que l'ouverture élargie (11) de la portion de positionnement.

7. Panneau d'affichage selon la revendication 6, **caractérisé en ce qu'**il comprend en outre des moyens de verrouillage (15) pour retenir le cache d'ornement (4, 40) dans la position d'assemblage en l'empêchant de tourner.

8. Panneau d'affichage selon l'une, quelconque, des revendications précédentes, **caractérisé en ce que** les moyens de verrouillage (15) comprennent un premier trou de verrouillage (16) agencé à travers une face supérieure (17) du cache d'ornement (4, 40), et un deuxième trou de verrouillage (18) agencé sur une face supérieure (19) de l'armature (4), ainsi qu'un loquet amovible (21) configuré pour pouvoir être inséré dans le premier (16) et le deuxième (18) trou de verrouillage.

9. Panneau d'affichage selon la revendication 8, caractérisé en ce le premier trou de verrouillage (16) et le deuxième trou de verrouillage (18) sont en vis-à-vis, lorsque le cache d'ornement (4, 40) est dans la position d'assemblage sur l'armature (2).

10. Panneau d'affichage selon l'une, quelconque, des revendications précédentes, **caractérisé en ce que** l'armature (2) et le cache d'ornement (4) entourent le premier écran d'affichage (3) en entier.

11. Panneau d'affichage selon l'une, quelconque, des revendications précédentes, **caractérisé en ce qu'**il comprend un deuxième écran d'affichage (22) agencé sous le premier écran d'affichage (3).

12. Panneau d'affichage selon la revendication 11, **caractérisé en ce que** le cache d'ornement (40) comprend une partie rectangulaire (42) destinée à entourer le deuxième écran d'affichage (22).

13. Panneau d'affichage selon l'une, quelconque, des revendications précédentes, **caractérisé en ce qu'**il comprend des moyens de suspension (20) pour pouvoir être suspendu.
